# EUROPÄISCHE PATENTSCHRIFT

(11) **EP 2 581 947 B1**
(45) Veröffentlichungstag und Bekanntmachung des Hinweises auf die Patenterteilung: **18.06.2014**
(21) Anmeldenummer: 12187605.6
(22) Anmeldetag: 08.10.2012
(51) Int. Cl.: H01L 31/048, B32B 27/08, B32B 27/34, B32B 27/36, B32B 7/12

(54) **Verwendung einer Mehrschichtfolie mit Polyamid- und Polyesterschichten für die Herstellung photovoltaischer Module**
Use of a multilayered film comprising polyamide and polyester layers for the production of photovoltaic modules
Utilisation d'une feuille multicouche comprenant des couches de polyamide et de polyester pour la fabrication de modules photovoltaïques

(30) Priorität: 14.10.2011 DE 102011084518
(43) Veröffentlichungstag der Anmeldung: 17.04.2013
(73) Patentinhaber: Evonik Industries AG, 45128 Essen (DE)
(72) Erfinder: Pawlik, Andreas, 45657 Recklinghausen (DE); Wielpütz, Martin, 48308 Senden (DE); Häger, Harald, 59348 Lüdinghausen (DE)

(56) Entgegenhaltungen:
- EP-A1- 0 837 088
- EP-A1- 1 645 409
- EP-A1- 2 422 976
- EP-A2- 1 065 048
- EP-A2- 1 217 039
- WO-A1-2008/138022

## Beschreibung

Die Erfindung betrifft die Verwendung einer Mehrschichtfolie mit Polyamid- und Polyesterschichten für die Herstellung von Solarmodulen.

Solarmodule, häufig auch als photovoltaische Module bezeichnet, dienen zur elektrischen Energieerzeugung aus Sonnenlicht und bestehen aus einem Laminat, welches als Kernschicht ein Solarzellensystem enthält. Diese Kernschicht ist mit Einkapselungsmaterialien umhüllt, die als Schutz gegen mechanische und witterungsbedingte Einflüsse dienen.

Die aktive Solarzelle befindet sich hierbei zwischen einer Frontabdeckung und einer Rückabdeckung. Die Frontabdeckung ist lichtdurchlässig und besteht im Regelfall aus Glas; sie ist mittels einer Haftvermittlerschicht, die häufig aus einem EthylenVinylacetat-Copolymeren besteht, mit der die Solarzelle enthaltenden Schicht verbunden. Die Rückabdeckung garantiert elektrische Abschirmung und dient als Schutz gegen Witterungseinflüsse, wie UV-Licht, und als Feuchtigkeitsbarriere.

Für die Rückabdeckung werden zur Zeit standardmäßig Folienverbunde aus Fluorpolymerfolien und Polyester verwendet. Die Fluorpolymerfolie an der Außenseite garantiert dabei die Witterungsbeständigkeit, die Polyesterfolie die mechanische Stabilität und die gewünschten elektrischen Isolationseigenschaften. Eine weitere Fluorpolymerfolie an der Innenseite dient zur Anbindung an die Siegelschicht des Solarzellensystems. Allerdings weisen derartige Fluorpolymerfolien nur eine geringe Haftung zur Siegelschicht auf, die als Einbettungsmaterial für die Solarzellen selbst verwendet wird. Darüber hinaus trägt die Fluorpolymerfolie nur in untergeordnetem Maß zur elektrischen Isolierung bei, woraus die Notwendigkeit der Verwendung einer vergleichsweise dicken Polyesterfolie resultiert.

In der WO 2008138022 wird daher vorgeschlagen, bei derartigen Verbunden die beiden Fluorpolymerfolien durch Folien aus Polyamid 12 (PA12) zu ersetzen. In einer Weiterbildung hiervon wird in der WO 2011066595 vorgeschlagen, dass die der Solarzelle zugewandte Thermoplastschicht einen Licht reflektierenden Füllstoff wie Titandioxid enthält, während die der Solarzelle abgewandte Thermoplastschicht einen zweiten Füllstoff, wie Glasfasern, Wollastonit oder Glimmer enthält, der eine höhere Wärmeleitfähigkeit dieser Schicht bewirkt. Beispielhafte Thermoplaste entstammen der Gruppe der Polyamide, Polyester oder Blends aus Polyamid und Polyolefin. Explizit genannt werden PA11, PA12 und PA1010 sowie deren Blends mit Polyolefinen.

Allerdings wird bei derartigen Thermoplastkombinationen keine ausreichende Haftung der Schichten erreicht, wobei insbesondere die Kombination aus Polyestern und Polyamiden zu nennen ist.

Die Aufgabe der Erfindung ist es, hierfür eine haftvermittelnde Lösung zur Verfügung zur stellen, die über die gesamte Standzeit des Verbundes hinweg, also über mehr als 20 Jahre, ungeachtet aller atmosphärischen Einwirkungen, eine feste Haftung zwischen den Schichten gewährleistet.

In der EP 1 065 048 A2 werden mehrschichtige Verbunde aus unverträglichen Polyamiden und/oder Polyestern beschrieben, die über eine Haftvermittlerschicht miteinander verbunden sind. Die Haftvermittlerschicht enthält ein Pfropfcopolymer, das aus einem Polyaminteil und aufgepfropften Polyamidketten besteht.

In dieser Schrift wird aber nicht belegt, dass das Pfropfcopolymer statt in einer Haftvermittlerschicht auch in einer Funktionsschicht verwendet werden kann, und dass auch die Haftung zwischen Schichten verbessert werden kann, die erhebliche Mengen an Füllstoffen enthalten. Darüber hinaus wird in dieser Schrift auch nicht offenbart, in welcher Weise sich bei dieser speziellen Anwendung das Haftungsniveau im Laufe der Jahre ändert, wenn eine entsprechende Folie der Witterung ausgesetzt ist.

Die Aufgabe wurde gelöst durch die Verwendung einer Mehrschichtfolie als Rückabdeckung eines photovoltaischen Moduls, wobei die Mehrschichtfolie folgende Schichten enthält:
a) Eine der Solarzelle zugewandte Schicht aus einer Formmasse, die einen Polyamidanteil von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, jeweils bezogen auf die gesamte Formmasse, enthält,
c) eine Mittelschicht aus einer Formmasse, die einen Anteil an thermoplastischem Polyester von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, jeweils bezogen auf die gesamte Formmasse, enthält, sowie
e) eine nach außen hin angeordnete Schicht aus einer Formmasse, die einen Polyamidanteil von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, jeweils bezogen auf die gesamte Formmasse, enthält,
und wobei eine Haftung zwischen den Schichten gemäß a) und c) sowie zwischen den Schichten gemäß c) und e) durch eine Maßnahme erzeugt wird, die ausgewählt ist aus
1. Zusatz eines Polyamin-Polyamid-Pfropfcopolymers zur Schicht gemäß a) bzw.
   zur Schicht gemäß e) in einer solchen Menge, dass in diesen Schichten jeweils 0,1 bis 60 Gew.-%, vorzugsweise jeweils 1 bis 50 Gew.-% und besonders bevorzugt jeweils 3 bis 40 Gew.-%, bezogen auf die jeweilige Formmasse, an Polyamin-Polyamid-Pfropfcopolymer enthalten ist;
2. Zusatz eines Polyamin-Polyamid-Pfropfcopolymers zur Schicht gemäß c) in einer solchen Menge, dass in dieser Schicht 0,1 bis 30 Gew.-% und vorzugsweise 1 bis 20 Gew.-%, bezogen auf die Formmasse, an Polyamin-Polyamid-Pfropfcopolymer enthalten ist;
3. Einbringen einer Haftvermittlerschicht b) zwischen den Schichten gemäß a) und c) und/oder einer Haftvermittlerschicht d) zwischen den Schichten gemäß c) und e), wobei die Haftvermittlerschicht bzw. die beiden Haftvermittlerschichten aus einer Formmasse bestehen, die folgende Komponenten enthält:
   I. 0,1 bis 100 Gew.-%, bevorzugt 1 bis 75 Gew.-%, besonders bevorzugt 3 bis 50 Gew.-% und insbesondere bevorzugt 4 bis 40 Gew.-% eines Polyamin-Polyamid-Pfropfcopolymers,
   II. 0 bis 99,9 Gew.-%, bevorzugt 12,5 bis 99 Gew.-%, besonders bevorzugt 25 bis 97 Gew.-% und insbesondere bevorzugt 30 bis 96 Gew.-% Polyamid,
   III. 0 bis 99,9 Gew.-%, bevorzugt 12,5 bis 99 Gew.-%, besonders bevorzugt 25 bis 97 Gew.-% und insbesondere bevorzugt 30 bis 96 Gew.-% thermoplastischen Polyester sowie
   IV. 0 bis 40 Gew.-% und vorzugsweise 0,1 bis 30 Gew.-% Zusatzstoffe ausgewählt aus schlagzähmachendem Kautschuk und üblichen Hilfs- bzw. Zuschlagstoffen,
   wobei die Prozentangaben jeweils auf die gesamte Formmasse bezogen sind,
mit der Maßgabe, dass das Polyamin-Polyamid-Pfropfcopolymer unter Verwendung folgender Monomere hergestellt wird:
a) 0,5 bis 25 Gew.-%, bevorzugt 1 bis 20 Gew.-% und besonders bevorzugt 1,5 bis 16 Gew.-%, bezogen auf das Pfropfcopolymer, eines Polyamins mit mindestens 4, bevorzugt mindestens 8 und besonders bevorzugt mindestens 11 Stickstoffatomen sowie
b) polyamidbildende Monomere, ausgewählt aus Lactamen, ω-Aminocarbonsäuren und/oder äquimolaren Kombinationen von Diamin und Dicarbonsäure.

Es sind also verschiedene Ausführungsformen denkbar:
In einer ersten Ausführungsform enthält die Mehrschichtfolie unmittelbar aufeinanderfolgend die Schichten gemäß a), c) und e). Sowohl die Formmasse der Schicht gemäß a) als auch die Formmasse der Schicht gemäß e) enthalten die der Maßnahme 1 entsprechende Menge an Polyamin-Polyamid-Pfropfcopolymer.

In einer zweiten Ausführungsform enthält die Mehrschichtfolie unmittelbar aufeinanderfolgend die Schichten gemäß a), c) und e). Die Formmasse der Schicht gemäß c) enthält die der Maßnahme 2 entsprechende Menge an Polyamin-Polyamid-Pfropfcopolymer.

In einer dritten Ausführungsform enthält die Mehrschichtfolie unmittelbar aufeinanderfolgend die Schichten gemäß a), b), c), d) und e). Die Schichten gemäß b) und d) sind Haftvermittlerschichten mit einer Zusammensetzung, wie sie unter der Maßnahme 3 wiedergegeben ist.

In einer vierten Ausführungsform enthält die Mehrschichtfolie unmittelbar aufeinanderfolgend die Schichten gemäß a), c), d) und e). Die Formmasse der Schicht gemäß a) enthält die der Maßnahme 1 entsprechende Menge an Polyamin-Polyamid-Pfropfcopolymer. Die Schicht gemäß d) ist eine Haftvermittlerschicht mit einer Zusammensetzung, wie sie unter der Maßnahme 3 wiedergegeben ist.

In einer fünften Ausführungsform enthält die Mehrschichtfolie unmittelbar aufeinanderfolgend die Schichten gemäß a), b), c) und e). Die Formmasse der Schicht gemäß e) enthält die der Maßnahme 1 entsprechende Menge an Polyamin-Polyamid-Pfropfcopolymer. Die Schicht gemäß b) ist eine Haftvermittlerschicht mit einer Zusammensetzung, wie sie unter der Maßnahme 3 wiedergegeben ist.

Die folgenden näheren Ausführungen gelten, sofern nichts anderes angegeben ist, für alle diese Ausführungsformen gleichermaßen.

Das Polyamid kann ein teilkristallines Polyamid sein wie beispielsweise PA6, PA66, PA610, PA612, PA10, PA810, PA106, PA1010, PA11, PA1011, PA1012, PA1210; PA1212, PA814, PA1014, PA618, PA512, PA613, PA813, PA914, PA1015, PA11, PA12 oder ein teilaromatisches Polyamid, ein sogenanntes Polyphthalamid (PPA). (Die Kennzeichnung der Polyamide entspricht internationaler Norm, wobei die erste(n) Ziffer(n) die C-Atomzahl des Ausgangsdiamins und die letzte(n) Ziffer(n) die C-Atomzahl der Dicarbonsäure angeben. Wird nur eine Zahl genannt, so bedeutet dies, dass von einer α,ω-Aminocarbonsäure bzw. von dem davon abgeleiteten Lactam ausgegangen worden ist; im übrigen sei verwiesen auf H. Domininghaus, Die Kunststoffe und ihre Eigenschaften, Seiten 272 ff., VDI-Verlag, 1976.) Geeignete PPAs sind beispielsweise PA66/6T, PA6/6T, PA6T/MPMDT (MPMD steht für 2-Methylpentamethylendiamin), PA9T, PA10T, PA11T, PA12T, PA14T sowie Copolykondensate dieser letzten Typen mit einem aliphatischen Diamin und einer aliphatischen Dicarbonsäure oder mit einer ω-Aminocarbonsäure bzw. einem Lactam. Teilkristalline Polyamide besitzen eine Schmelzenthalpie von mehr als 25 J/g, gemessen mit der DSC-Methode gemäß ISO 11357 beim 2. Aufheizen und Integration des Schmelzpeaks.

Das Polyamid kann aber auch ein semikristallines Polyamid sein. Semikristalline Polyamide besitzen eine Schmelzenthalpie von 4 bis 25 J/g, gemessen mit der DSC-Methode gemäß ISO 11357 beim 2. Aufheizen und Integration des Schmelzpeaks. Beispiele für geeignete semikristalline Polyamide sind
- Das Polyamid aus 1,10-Decandisäure oder 1,12-Dodecandisäure und 4,4'-Diaminodicyclohexylmethan (PA PACM10 und PA PACM12), ausgehend von einem 4,4'-Diaminodicyclohexylmethan mit einem trans,trans-Isomerenanteil von 35 bis 65 %;
- Copolymere auf Basis der obengenannten teilkristallinen Polyamide; sowie
- Blends aus den obengenannten teilkristallinen Polyamiden und einem damit verträglichen amorphen Polyamid.

Das Polyamid kann auch ein amorphes Polyamid sein. Amorphe Polyamide besitzen eine Schmelzenthalpie von weniger als 4 J/g, gemessen mit der DSC-Methode gemäß ISO 11357 beim 2. Aufheizen und Integration des Schmelzpeaks. Beispiele für amorphe Polyamide sind:
- das Polyamid aus Terephthalsäure und/oder Isophthalsäure und dem Isomerengemisch aus 2.2.4- und 2.4.4-Trimethylhexamethylendiamin,
- das Polyamid aus Isophthalsäure und 1.6-Hexamethylendiamin,
- das Copolyamid aus einem Gemisch aus Terephthalsäure/Isophthalsäure und 1.6-Hexamethylendiamin, gegebenenfalls in Mischung mit 4.4'-Diaminodicyclohexylmethan,
- das Copolyamid aus Terephthalsäure und/oder Isophthalsäure, 3.3'-Dimethyl-4.4'-diaminodicyclohexylmethan und Laurinlactam oder Caprolactam,
- das (Co)Polyamid aus 1.12-Dodecandisäure oder Sebacinsäure, 3.3'-Dimethyl-4.4'-diaminodicyclohexylmethan und gegebenenfalls Laurinlactam oder Caprolactam,
- das Copolyamid aus Isophthalsäure, 4.4'-Diaminodicyclohexylmethan und Laurinlactam oder Caprolactam,
- das Polyamid aus 1.12-Dodecandisäure und 4.4'-Diaminodicyclohexylmethan (bei niedrigem trans,trans-Isomerenanteil),
- das (Co)Polyamid aus Terephthalsäure und/oder Isophthalsäure sowie einem alkylsubstituierten Bis(4-aminocyclohexyl)methan-Homologen, gegebenenfalls in Mischung mit Hexamethylendiamin,
- das Copolyamid aus Bis(4-amino-3-methyl-5-ethyl-cyclohexyl)methan, gegebenenfalls zusammen mit einem weiteren Diamin, sowie Isophthalsäure, gegebenenfalls zusammen mit einer weiteren Dicarbonsäure,
- das Copolyamid aus einer Mischung von m-Xylylendiamin und einem weiteren Diamin, z. B. Hexamethylendiamin, sowie Isophthalsäure, gegebenenfalls zusammen mit einer weiteren Dicarbonsäure wie z. B. Terephthalsäure und/oder 2,6-Naphthalindicarbonsäure,
- das Copolyamid aus einer Mischung von Bis(4-amino-cyclohexyl)methan und Bis-(4-amino-3-methyl-cyclohexyl)methan sowie aliphatischen Dicarbonsäuren mit 8 bis 14 C-Atomen, sowie
- Polyamide oder Copolyamide aus einer Mischung, die 1.14-Tetradecandisäure sowie ein aromatisches, arylaliphatisches oder cycloaliphatisches Diamin enthält.

Diese Beispiele können durch Hinzunahme weiterer Komponenten (z. B. Caprolactam, Laurinlactam oder Diamin/Dicarbonsäure-Kombinationen) oder durch teilweisen oder vollständigen Ersatz von Ausgangskomponenten durch andere Komponenten weitestgehend variiert werden.

Das Polyamid kann auch ein Polyetheresteramid oder ein Polyetheramid sein. Polyetheresteramide sind z. B. aus der DE-A-25 23 991 und der DE-A-27 12 987 bekannt; sie enthalten als Comonomer ein Polyetherdiol. Polyetheramide sind beispielsweise aus der DE-A- 30 06 961 bekannt; sie enthalten als Comonomer ein Polyetherdiamin.

Beim Polyetherdiol bzw. dem Polyetherdiamin kann die Polyethereinheit beispielsweise auf 1.2-Ethandiol, 1.2-Propandiol, 1.3-Propandiol, 1.4-Butandiol oder 1.3-Butandiol basieren. Die Polyethereinheit kann auch gemischt aufgebaut sein, etwa mit statistischer oder blockweiser Verteilung der von den Diolen herrührenden Einheiten. Das Gewichtsmittel der Molmasse der Polyetherdiole bzw. Polyetherdiamine liegt bei 200 bis 5000 g/mol und vorzugsweise bei 400 bis 3000 g/mol; ihr Anteil am Polyetheresteramid bzw. Polyetheramid beträgt bevorzugt 4 bis 60 Gew.-% und besonders bevorzugt 10 bis 50 Gew.-%. Geeignete Polyetherdiamine sind durch Konversion der entsprechenden Polyetherdiole durch reduktive Aminierung oder Kupplung an Acrylnitril mit nachfolgender Hydrierung zugänglich; sie sind z. B. in Form der JEFFAMIN^{®} D- oder ED-Typen oder der ELASTAMINE^{®}-Typen bei der Huntsman Corp. oder in Form der Polyetheramin D-Reihe bei der BASF SE kommerziell erhältlich. In geringeren Mengen kann auch ein Polyethertriamin mit verwendet werden, z. B. ein JEFFAMIN^{®} T-Typ, falls ein verzweigtes Polyetheramid eingesetzt werden soll. Vorzugsweise setzt man Polyetherdiamine bzw. Polyethertriamine ein, die pro Ethersauerstoffatom im Mittel mindestens 2,3 Kohlenstoffatome in der Kette enthalten. Erfindungsgemäß sind Polyetheramide wegen der besseren Hydrolysebeständigkeit bevorzugt.

Als thermoplastischer Polyester kommen linear aufgebaute, thermoplastische Polyester infrage. Diese werden durch Polykondensation von Diolen mit Dicarbonsäure bzw. deren polyesterbildenden Derivaten wie Dimethylestern hergestellt. Geeignete Diole haben die Formel HO-R-OH, wobei R einen divalenten, verzweigten oder unverzweigten aliphatischen und/oder cycloaliphatischen Rest mit 2 bis 40, vorzugsweise 2 bis 12, C-Atomen darstellt. Geeignete Dicarbonsäuren haben die Formel HOOC-R'-COOH, wobei R' einen divalenten aromatischen Rest mit 6 bis 20, vorzugsweise 6 bis 12, C-Atomen bedeutet.

Als Beispiel für Diole seien Ethylenglykol, Trimethylenglykol, Tetramethylenglykol, Hexamethylenglykol, Neopentylglykol, Cyclohexandimethanol sowie das C₃₆-Diol Dimerdiol genannt. Die Diole können alleine oder als Diolgemisch eingesetzt werden. Bis zu 25 Mol-% des genannten Diols können durch ein Polyalkylenglykol mit nachstehender allgemeiner Formel ersetzt sein, 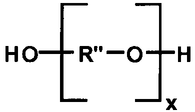 wobei R" einen zweiwertigen Rest mit 2 bis 4 C-Atomen bedeutet und x einen Wert von 2 bis 50 annehmen kann.

Als aromatische Dicarbonsäuren kommen z. B. Terephthalsäure, Isophthalsäure, 1.4-, 1.5-, 2.6- bzw. 2.7-Naphthalindicarbonsäure, Diphensäure und Diphenylether-4.4'-dicarbonsäure infrage. Bis zu 30 Mol-% dieser Dicarbonsäuren können durch aliphatische oder cycloaliphatische Dicarbonsäuren wie z. B. Bernsteinsäure, Adipinsäure, Sebacinsäure, Dodecandisäure oder Cyclohexan-1.4-dicarbonsäure ersetzt sein.

Beispiele für geeignete Polyester sind Polyethylenterephthalat, Polypropylenterephthalat, Polybutylenterephthalat, Polyethylen-2.6-naphthalat, Polypropylen-2.6-naphthalat und Polybutylen-2.6-naphthalat.

Die Herstellung dieser Polyester gehört zum Stand der Technik (DE-OSS 24 07 155, 24 07 156; Ullmanns Encyclopädie der technischen Chemie, 4. Aufl., Bd. 19, Seiten 65 ff., Verlag Chemie, Weinheim, 1980).

Als Polyamin des Polyamin-Polyamid-Pfropfcopolymers können beispielsweise folgende Substanzklassen verwendet werden:
- Polyvinylamine (Römpp Chemie Lexikon, 9. Auflage, Band 6, Seite 4921, Georg Thieme Verlag Stuttgart 1992)
- Polyamine, die aus alternierenden Polyketonen hergestellt werden (DE-OS 196 54 058)
- Dendrimere wie beispielsweise ((H₂N-(CH₂)₃)₂N-(CH₂)₃)₂-N(CH₂)₂-N((CH₂)₂-N((CH₂)₃-NH₂)₂)₂ (DE-A-196 54 179) oder
   Tris(2-aminoethyl)amin, N,N-Bis(2-aminoethyl)-N',N'-bis[2-[bis(2-aminoethyl)amino]ethyl]-1,2-ethandiamin,
   3,15-Bis(2-aminoethyl)-6,12-bis[2-[bis(2-aminoethyl)amino]ethyl]-9-[2-[bis[2-bis(2-aminoethyl)amino]ethyl]amino]ethyl]3,6,9,12,15-pentaazaheptadecan-1,17-diamin (J. M. Warakomski, Chem. Mat. 1992, 4, 1000 - 1004);
- lineare Polyethylenimine, die durch Polymerisation von 4,5-Dihydro-1,3-oxazolen und anschließende Hydrolyse hergestellt werden können (Houben-Weyl, Methoden der Organischen Chemie, Band E20, Seiten 1482 - 1487, Georg Thieme Verlag Stuttgart, 1987);
- verzweigte Polyethylenimine, die durch Polymerisation von Aziridinen erhältlich sind (Houben-Weyl, Methoden der Organischen Chemie, Band E20, Seiten 1482 - 1487, Georg Thieme Verlag Stuttgart, 1987) und die in der Regel folgende Aminogruppenverteilung besitzen:
   25 bis 46 % primäre Aminogruppen,
   30 bis 45 % sekundäre Aminogruppen und
   16 bis 40 % tertiäre Aminogruppen.

Das Polyamin besitzt im bevorzugten Fall ein zahlenmittleres Molekulargewicht Mₙ von maximal 20 000 g/mol, besonders bevorzugt von maximal 10 000 g/mol und insbesondere bevorzugt von maximal 5 000 g/mol.

Lactame bzw. ω-Aminocarbonsäuren, die als polyamidbildende Monomere eingesetzt werden, enthalten 4 bis 19 und insbesondere 6 bis 12 Kohlenstoffatome. Besonders bevorzugt werden Caprolactam, ω-Aminocapronsäure, Capryllactam, ω-Aminocaprylsäure, Laurinlactam, ω-Aminododecansäure und/oder ω-Aminoundecansäure eingesetzt.

Kombinationen von Diamin und Dicarbonsäure sind beispielsweise Hexamethylendiamin/Adipinsäure, Hexamethylendiamin/Dodecandisäure, Octamethylendiamin/Sebacinsäure, Decamethylendiamin/Sebacinsäure, Decamethylendiamin/Dodecandisäure, Dodecamethylendiamin/Dodecandisäure und Dodecamethylendiamin/2,6-Naphthalindicarbonsäure. Daneben können aber auch alle anderen Kombinationen eingesetzt werden wie Decamethylendiamin/Dodecandisäure/Terephthalsäure, Hexamethylendiamin/-Adipinsäure/Terephthalsäure, Hexamethylendiamin/Adipinsäure/Caprolactam, Decamethylendiamin/Dodecandisäure/ω-Aminoundecansäure, Decamethylendiamin/Dodecandisäure/Laurinlactam, Decamethylendiamin/- Terephthalsäure/Laurinlactam oder Dodecamethylendiamin/2,6-Naphthalindicarbonsäure/Laurinlactam.

In einer bevorzugten Ausführungsform wird das Pfropfcopolymer zusätzlich unter Verwendung einer Oligocarbonsäure hergestellt, die ausgewählt ist aus 0,015 bis etwa 3 Mol-% Dicarbonsäure und 0,01 bis etwa 1,2 Mol-% Tricarbonsäure, jeweils bezogen auf die Summe der übrigen polyamidbildenden Monomere. Bei dieser Bezugnahme wird bei der äquivalenten Kombination von Diamin und Dicarbonsäure jedes dieser Monomere einzeln betrachtet. Auf diese Weise besitzen die polyamidbildenden Monomere insgesamt einen leichten Überschuss an Carboxylgruppen. Wird eine Dicarbonsäure verwendet, setzt man bevorzugt 0,03 bis 2,2 Mol-%, besonders bevorzugt 0,05 bis 1,5 Mol-%, ganz besonders bevorzugt 0,1 bis 1 Mol-% und insbesondere 0,15 bis 0,65 Mol-% zu; verwendet man eine Tricarbonsäure, so nimmt man vorzugsweise 0,02 bis 0,9 Mol-%, besonders bevorzugt 0,025 bis 0,6 Mol-%, ganz besonders bevorzugt 0,03 bis 0,4 Mol-% und inbesondere 0,04 bis 0,25 Mol-%. Durch die Mitverwendung der Oligocarbonsäure wird die Hydrolysebeständigkeit und die Spannungsrißbeständigkeit deutlich verbessert.

Als Oligocarbonsäure kann jede beliebige Di- oder Tricarbonsäure mit 6 bis 24 C-Atomen eingesetzt werden, beispielsweise Adipinsäure, Korksäure, Azelainsäure, Sebacinsäure, Dodecandisäure, Isophthalsäure, 2,6-Naphthalindicarbonsäure, Cyclohexan-1.4-dicarbonsäure, Trimesinsäure und/oder Trimellitsäure.

Zusätzlich können, falls gewünscht, aliphatische, alicyclische, aromatische, aralkylische und/oder alkylarylsubstituierte Monocarbonsäuren mit 3 bis 50 Kohlenstoffatomen wie z. B. Laurylsäure, ungesättigte Fettsäuren, Acrylsäure oder Benzoesäure als Regler eingesetzt werden. Mit diesen Reglern kann die Konzentration an Aminogruppen verringert werden, ohne die Molekülgestalt zu verändern. Zusätzlich können auf diese Weise funktionelle Gruppen wie Doppel- bzw. Dreifachbindungen etc. eingeführt werden. Es ist aber erwünscht, daß das Pfropfcopolymer einen substantiellen Anteil an Aminogruppen besitzt. In einer bevorzugten Ausführungsform liegt die Aminogruppenkonzentration des Pfropfcopolymers im Bereich von 100 bis 2 500 mmol/kg, besonders bevorzugt im Bereich von 150 bis 1 500 mmol/kg, insbesondere bevorzugt im Bereich von 250 bis 1 300 mmol/kg und ganz besonders bevorzugt im Bereich von 300 bis 1 100 mmol/kg. Unter Aminogruppen werden hier und im folgenden nicht nur Aminoendgruppen, sondern auch gegebenenfalls vorhandene sekundäre bzw. tertiäre Aminfunktionen des Polyamins verstanden.

Die erfindungsgemäßen Pfropfcopolymere können nach verschiedenen Verfahren hergestellt werden.

Eine Möglichkeit besteht darin, Lactam bzw. ω-Aminocarbonsäure und Polyamin zusammen vorzugeben und die Polymerisation bzw. die Polykondensation durchzuführen. Die Oligocarbonsäure kann entweder am Anfang oder im Verlauf der Reaktion zugegeben werden.

Ein bevorzugtes Verfahren besteht jedoch darin, daß in einem zweistufigen Prozeß zuerst die Lactamspaltung und Präpolymerisation in Gegenwart von Wasser durchgeführt wird (alternativ werden die entsprechenden ω-Aminocarbonsäuren bzw. Diamine und Dicarbonsäuren direkt eingesetzt und präpolymerisiert); im zweiten Schritt wird das Polyamin zugegeben, während die gegebenenfalls mitverwendete Oligocarbonsäure vor, während oder nach der Präpolymerisation zudosiert wird. Dann wird bei Temperaturen zwischen 200 und 290 °C entspannt und im Stickstoffstrom oder im Vakuum polykondensiert.

Ein weiteres bevorzugtes Verfahren besteht im hydrolytischen Abbau eines Polyamids zu einem Präpolymer und gleichzeitige oder anschließende Reaktion mit dem Polyamin. Vorzugsweise werden Polyamide verwendet, bei denen die Endgruppendifferenz näherungsweise Null beträgt, oder bei denen die gegebenenfalls mitverwendete Oligocarbonsäure bereits einpolykondensiert ist. Die Oligocarbonsäure kann aber auch zu Anfang oder im Laufe der Abbaureaktion zugegeben werden.

Mit diesen Verfahren lassen sich ultrahochverzweigte Polyamide mit Säurezahlen kleiner als 40 mmol/kg, bevorzugt kleiner als 20 mmol/kg und besonders bevorzugt kleiner als 10 mmol/kg herstellen. Schon nach ein- bis fünfstündiger Reaktionszeit bei Temperaturen von 200 °C bis 290 °C wird ein annähernd vollständiger Umsatz erzielt.

Falls gewünscht, kann in einem weiteren Verfahrensschritt eine mehrstündige Vakuumphase angeschlossen werden. Diese dauert mindestens vier Stunden, bevorzugt mindestens sechs Stunden und besonders bevorzugt mindestens acht Stunden bei 200 bis 290 °C. Nach einer Induktionsperiode von mehreren Stunden wird dann eine Erhöhung der Schmelzeviskosität beobachtet, was darauf zurückzuführen sein dürfte, daß eine Reaktion von Aminoendgruppen miteinander unter Ammoniakabspaltung und Kettenverknüpfung stattfindet. Hierdurch wird das Molekulargewicht weiter erhöht, was insbesondere für Extrusionsformmassen vorteilhaft ist.

Falls man die Reaktion nicht in der Schmelze zu Ende führen will, kann das ultrahochverzweigte Polyamid gemäß dem Stand der Technik auch in fester Phase nachkondensiert werden.

Die Formmasse der Schicht gemäß a) kann entweder eines der obengenannten Polyamide oder mehrere als Gemisch enthalten. Weiterhin können bis zu 40 Gew.-%, bezogen auf den gesamten Polymeranteil der Formmasse, andere Thermoplaste enthalten sein, beispielsweise schlagzähmachende Kautschuke oder Polyolefine wie Polyethylen oder Polypropylen. Eventuell enthaltene Kautschuke oder Polyolefine enthalten vorzugsweise, dem Stand der Technik entsprechend, funktionelle Gruppen, mit denen eine Verträglichkeit mit der Polyamidmatrix erhalten wird. Darüber hinaus können die für Polyamide üblichen Hilfs- und Zusatzstoffe enthalten sein, insbesondere Licht- und/oder Wärmestabilisatoren, oder bevorzugt auch Licht reflektierende Füllstoffe wie beispielsweise Titandioxid (WO 2011066595). Bei der ersten und der vierten Ausführungsform ist zu berücksichtigen, dass zum anspruchsgemäßen Polyamidanteil auch der Polyamidanteil des Polyamin-Polyamid-Pfropfcopolymers zählt.

Die Formmasse der Schicht gemäß c) kann entweder einen der obengenannten Polyester oder mehrere als Gemisch enthalten. Weiterhin können bis zu 50 Gew.-% und vorzugsweise bis zu 40 Gew.-%, jeweils bezogen auf den gesamten Polymeranteil der Formmasse, andere Thermoplaste enthalten sein, beispielsweise schlagzähmachende Kautschuke oder Polyolefine wie Polyethylen oder Polypropylen, oder Polyamin-Polyamid-Pfropfcopolymer im Falle der zweiten Ausführungsform. Eventuell enthaltene Kautschuke oder Polyolefine enthalten vorzugsweise, dem Stand der Technik entsprechend, funktionelle Gruppen; zusätzlich oder alternativ hierzu kann ein Verträglichkeitsvermittler zugesetzt werden. Darüber hinaus können die für Polyester üblichen Hilfs- und Zusatzstoffe enthalten sein, insbesondere Licht- und/oder Wärmestabilisatoren, Licht reflektierende Füllstoffe wie beispielsweise Titandioxid sowie verstärkende Füllstoffe wie beispielsweise Glasfasern, Wollastonit oder Glimmer.

Für die Formmasse der Schicht gemäß e) gilt das Gleiche wie für die Formmasse der Schicht gemäß a) sowie hinsichtlich Füllstoffen das Gleiche wie für die Formmasse der Schicht gemäß c). Zusätzlich kann die Formmasse der Schicht gemäß e) eingefärbt sein und/oder ein Mattierungsmittel aufweisen.

Die einzelnen Folienschichten weisen in der Regel folgende Dicken auf:
- Schichten gemäß a) und e): 15 bis100 µm und vorzugsweise 25 bis 50 µm;
- Schicht gemäß c): 100 bis 500 µm und vorzugsweise 150 bis 400 µm;
- Schichten gemäß b) und d): 3 bis 40 µm und vorzugsweise 5 bis 25 µm.

Die erfindungsgemäß verwendete Mehrschichtfolie kann nach allen Methoden des Standes der Technik hergestellt werden, beispielsweise durch Coextrusion oder Laminieren. Sie wird mit der Siegelschicht, in die die Solarzelle eingebettet ist, beispielsweise durch Laminieren oder Kleben verbunden. Wegen des Polyamidanteils in der Schicht gemäß a) wird beim Laminieren eine gute Haftung zur Siegelschicht erhalten. Als Siegelschicht kann jedes gemäß dem Stand der Technik gebräuchliche Material verwendet werden.

Gegenstand der Erfindung ist auch ein photovoltaisches Modul, das unter Verwendung der anspruchsgemäßen Mehrschichtfolie hergestellt wurde.

Die Erfindung wird nachfolgend beispielhaft erläutert. Hierzu wurden folgende Formmassen hergestellt; bei "Teilen" handelt es sich immer um Gewichtsteile.

### Compound 1 für Außenschichten:

79,25 Teile VESTAMID^{®} L1901 nf (PA12), 0,5 Teile IRGANOX^{®} 1098 (ein sterisch gehindertes phenolisches Antioxidans), 0,2 Teile TINUVIN^{®} 312 (UV-Absorber) und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound 2 für Außenschichten:

69,25 Teile VESTAMID^{®} L1901 nf, 10 Teile Polyamin-Polyamid-Pfropfcopolymer (hergestellt gemäß EP 1 065 236 A2 aus 87,063 Gew.-% Laurinlactam, 0,164 Gew.-% Dodecandisäure, 8,205 Gew.-% Lupasol^{®} G 100 50%ig, 0,010 Gew.-% unterphosphorige Säure 50%ig sowie 4,558 Gew.-% VE-Wasser), 0,5 Teile IRGANOX^{®} 1098, 0,2 Teile TINUVIN^{®} 312 und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound 3 für Mittelschicht:

35,5 Teile VESTAMID^{®} L1901 nf, 44,0 Teile VESTODUR^{®} 3000 (PBT), 20 Teile Kaolin TEC 110, 0,25 Teile IRGAFOS^{®} 168 (Verarbeitungsstabilisator) und 0,25 Teile IRGANOX^{®} 1010 (sterisch gehindertes phenolisches Antioxidans) wurden mit Hilfe eines Zweiwellenextruders (Coperion Werner & Pfleiderer ZSK 25 WLE, 36 L/D) bei einer Zylindertemperatur von 260 °C gemischt. Der Strang wurde mit Hilfe eines Wasserbads gekühlt und geschnitten; das Granulat wurde anschließend 12 Stunden bei 80 °C im Umluftofen getrocknet.

### Compound 4 für Mittelschicht:

26,5 Teile VESTAMID^{®} L1901, 9,0 Teile des gleichen Polyamin-Polyamid-Pfropfcopolymers wie im Compound 2, 44,0 Teile VESTODUR^{®} 3000, 20 Teile Kaolin TEC 110, 0,25 Teile IRGAFOS^{®} 168 und 0,25 Teile IRGANOX^{®} 1010 wurden mit Hilfe eines Zweiwellenextruders (Coperion Werner & Pfleiderer ZSK 25 WLE, 36 L/D) bei einer Zylindertemperatur von 260 °C gemischt. Der Strang wurde mit Hilfe eines Wasserbads gekühlt und geschnitten; das Granulat wurde anschließend 12 Stunden bei 80 °C im Umluftofen getrocknet.

### Compound 5 für Haftvermittlerschicht:

51,6 Teile VESTODUR^{®} 3000, 9,0 Teile EXXELOR^{®} VA 1803 (ein mit Maleinsäureanhydrid funktionalisierter Ethylen-Propylen-Kautschuk), 26,0 Teile VESTAMID^{®} ZA7295nf (PA12-Extrusionstyp), 13,4 Teile des gleichen Polyamin-Polyamid-Pfropfcopolymers wie im Compound 2, 0,25 Teile IRGAFOS^{®} 168 und 0,25 Teile IRGANOX^{®} 1010 wurden mit Hilfe eines Zweiwellenextruders (Coperion Werner & Pfleiderer ZSK 25 WLE, 36 L/D) bei einer Zylindertemperatur von 260 °C gemischt. Der Strang wurde mit Hilfe eines Wasserbads gekühlt und geschnitten; das Granulat wurde anschließend 12 Stunden bei 80 °C im Umluftofen getrocknet.

### Extrusion mehrschichtiger Folien:

Mit einer Mehrschichtfolienanlage der Fa. Collin (Breitschlitzdüse 300 mm, Spalt 0 - 6 mm, Co-Extrusionsfeedblock für 3-schichtige bzw. 5-schichtige Folien) wurden drei - und fünfschichtige Folien hergestellt (Verarbeitungstemperatur für Mittelschicht sowie Haftvermittlerschichten ca. 260 °C, für Außenschichten ca. 230 °C). Die Schichtdickenverteilung wurde wie folgt eingestellt:

| | |
|---|---|
| a/c/e: | 50 µm / 250µm / 50 µm |
| a/b/c/d/e: | 50 µm /10 µm /230 µm /10 µm /50 µm |

Die Ergebnisse sind in der Tabelle 1 dargestellt.

**Tabelle 1: Beispiele**

| | Schichtaufbau | Interlaminare Haftung [N/mm] |
|---|---|---|
| Vergleichsbeispiel | Compound 1/Compound 3/Compound 1 | 0,3 |
| Beispiel 1 | Compound 2/Compound 3/Compound 2 | Trennung nicht möglich |
| Beispiel 2 | Compound 1/Compound 4/Compound 1 | Trennung nicht möglich |
| Beispiel 3 | Compound 1/Compound 5/Compound 3/Compound 5/Compound 1 | Trennung nicht möglich |

## Patentansprüche

1. Verwendung einer Mehrschichtfolie als Rückabdeckung eines photovoltaischen Moduls, wobei die Mehrschichtfolie folgende Schichten enthält:
a) Eine der Solarzelle zugewandte Schicht aus einer Formmasse, die einen Polyamidanteil von mindestens 35 Gew.-%, bezogen auf die gesamte Formmasse, enthält,
c) eine Mittelschicht aus einer Formmasse, die einen Anteil an thermoplastischem Polyester von mindestens 35 Gew.-%, bezogen auf die gesamte Formmasse, enthält, sowie
e) eine nach außen hin angeordnete Schicht aus einer Formmasse, die einen Polyamidanteil von mindestens 35 Gew.-%, bezogen auf die gesamte Formmasse, enthält,
**dadurch gekennzeichnet,**
**dass** die Haftung zwischen den Schichten gemäß a) und c) sowie zwischen den Schichten gemäß c) und e) durch eine Maßnahme erzeugt wird, die ausgewählt ist aus
1. Zusatz eines Polyamin-Polyamid-Pfropfcopolymers zur Schicht gemäß a) und/oder zur Schicht gemäß e) in einer solchen Menge, dass in diesen Schichten jeweils 0,1 bis 60 Gew.-%, bezogen auf die jeweilige Formmasse, an Polyamin-Polyamid-Pfropfcopolymer enthalten ist;
2. Zusatz eines Polyamin-Polyamid-Pfropfcopolymers zur Schicht gemäß c) in einer solchen Menge, dass in dieser Schicht 0,1 bis 30 Gew.-%, bezogen auf die Formmasse, an Polyamin-Polyamid-Pfropfcopolymer enthalten ist;
3. Einbringen einer Haftvermittlerschicht b) zwischen den Schichten gemäß a) und c) und/oder einer Haftvermittlerschicht d) zwischen den Schichten gemäß c) und e), wobei die Haftvermittlerschicht bzw. die beiden Haftvermittlerschichten aus einer Formmasse bestehen, die zu 60 bis 100 Gew.-% aus folgenden Komponenten besteht:
I. 0,1 bis 100 Gew.-% eines Polyamin-Polyamid-Pfropfcopolymers,
II. 0 bis 99,9 Gew.-% Polyamid sowie
III. 0 bis 99,9 Gew.-% thermoplastischer Polyester,
wobei die Prozentangaben von I., II. und III. sich auf die gesamte Formmasse beziehen,
mit der Maßgabe, dass das Polyamin-Polyamid-Pfropfcopolymer unter Verwendung folgender Monomerer hergestellt wird:
a) 0,5 bis 25 Gew.-%, bezogen auf das Pfropfcopolymer, eines Polyamins mit mindestens 4 Stickstoffatomen sowie
b) polyamidbildende Monomere, ausgewählt aus Lactamen, ω-Aminocarbonsäuren und/oder äquimolaren Kombinationen von Diamin und Dicarbonsäure.

2. Verwendung gemäß Anspruch 1,
**dadurch gekennzeichnet, dass**
• die Schichten gemäß a) und e) eine Dicke von 15 bis100 µm,
• die Schicht gemäß c) eine Dicke von 100 bis 500 µm und
• die Schichten gemäß b) und d) eine Dicke von 3 bis 40 µm besitzen.

3. Photovoltaisches Modul, erhalten unter Verwendung einer Mehrschichtfolie gemäß einem der vorhergehenden Ansprüche.

## Claims

1. Use of a multilayer film as a back cover of a photovoltaic module, said multilayer film comprising the following layers:
a) a solar cell-facing layer of a moulding composition comprising a polyamide content of at least 35% by weight, based on the overall moulding composition,
c) a middle layer of a moulding composition comprising a proportion of thermoplastic polyester of at least 35% by weight, based on the overall moulding composition, and
e) an outer layer of a moulding composition comprising a polyamide content of at least 35% by weight, based on the overall moulding composition,
**characterized in that**
the adhesion between the layers according to a) and c) and between the layers according to c) and e) is produced by a measure selected from
1. addition of a polyamine-polyamide graft copolymer to the layer according to a) and/or to the layer according to e) in such an amount that these layers each comprise 0.1 to 60% by weight, based on the respective moulding composition, of polyamine-polyamide graft copolymer;
2. addition of a polyamine-polyamide graft copolymer to the layer according to c) in such an amount that this layer comprises 0.1 to 30% by weight, based on the moulding composition, of polyamine-polyamide graft copolymer;
3. introduction of an adhesion promoter layer b) between the layers according to a) and c) and/or of an adhesion promoter layer d) between the layers according to c) and e), the adhesion promoter layer or the two adhesion promoter layers consisting of a moulding composition consisting to an extent of 60 to 100% by weight of the following components:
I. 0.1 to 100% by weight of a polyamine-polyamide graft copolymer,
II. 0 to 99.9% by weight of polyamide and
III. 0 to 99.9% by weight of thermoplastic polyesters,
where the percentages of I., II. and III. relate to the overall moulding composition,
with the proviso that the polyamine-polyamide graft copolymer is produced using the following monomers:
a) 0.5 to 25% by weight, based on the graft copolymer, of a polyamine having at least 4 nitrogen atoms and
b) polyamide-forming monomers selected from lactams, ω-aminocarboxylic acids and/or equi-molar combinations of diamine and dicarboxylic acid.

2. Use according to Claim 1,
**characterized in that**
• the layers according to a) and e) have a thickness of 15 to 100 µm,
• the layer according to c) a thickness of 100 to 500 µm and
• the layers according to b) and d) a thickness of 3 to 40 µm.

3. Photovoltaic module obtained using a multilayer film according to either of the preceding claims

## Revendications

1. Utilisation d'une feuille multicouche comme recouvrement arrière d'un module photovoltaïque, la feuille multicouche contenant les couches suivantes :
a) une couche orientée vers la cellule solaire en une masse de moulage qui contient une proportion de polyamide d'au moins 35% en poids par rapport à la totalité de la masse de moulage,
c) une couche centrale en une masse de moulage qui contient une proportion de polyester thermoplastique d'au moins 35% en poids par rapport à la totalité de la masse de moulage, ainsi que
e) une couche disposée vers l'extérieur en une masse de moulage qui contient une proportion de polyamide d'au moins 35% en poids par rapport à la totalité de la masse de moulage,
**caractérisée en ce que** l'adhérence entre les couches selon a) et c) ainsi qu'entre les couches selon c) et e) est générée par une mesure qui est choisie parmi
1. addition d'un copolymère greffé de polyamine-polyamide à la couche selon a) et/ou à la couche selon e) en une quantité telle que ces couches contiennent à chaque fois 0, 1 à 60% en poids, par rapport à la masse de moulage respective, de copolymère greffé de polyamine-polyamide ;
2. addition d'un copolymère greffé de polyamine-polyamide à la couche selon c) en une quantité telle que cette couche contient 0,1 à 30% en poids, par rapport à la masse de moulage, de copolymère greffé de polyamine-polyamide ;
3. introduction d'une couche de promoteur d'adhérence b) entre les couches selon a) et c) et/ou d'une couche de promoteur d'adhérence d) entre les couches selon c) et e), la couche ou les deux couches de promoteur d'adhérence étant constituée(s) d'une masse de moulage qui est constituée à raison de 60 à 100% en poids par les composants suivants :
I. 0,1 à 100% en poids d'un copolymère greffé de polyamine-polyamide,
II. 0 à 99,9% en poids de polyamide ainsi que
III. 0 à 99,9% en poids de polyester thermoplastique,
les indications en pourcent de I., II. et III. se rapportant à la totalité de la masse de moulage,
à condition que le copolymère greffé de polyamine-polyamide soit préparé en utilisant les monomères suivants :
a) 0,5 à 25% en poids, par rapport au copolymère greffé, d'une polyamine présentant au moins 4 atomes d'azote ainsi que
b) des monomères formant du polyamide, choisis parmi les lactames, les acides ω-aminocarboxyliques et/ou les combinaisons équimolaires de diamine et d'acide dicarboxylique.

2. Utilisation selon la revendication 1, **caractérisée en ce que**
- les couches selon a) et e) présentent une épaisseur de 15 à 100 µm,
- la couche selon c) présente une épaisseur de 100 à 500 µm et
- les couches selon b) et d) présentent une épaisseur de 3 à 40 µm.

3. Module photovoltaïque, obtenu en utilisant une feuille multicouche selon l'une quelconque des revendications précédentes.
